# EUROPEAN PATENT APPLICATION

(11) **EP 4 110 029 A1**
(43) Date of publication of application: **28.12.2022**
(21) Application number: 21189796.2
(22) Date of filing: 05.08.2021
(51) Int. Cl.: H05K 9/00

(54) **ESD SUPPRESSOR AND MANUFACTURING METHOD THEREOF**

(30) Priority: 25.06.2021 TW 110123785
(71) Applicant: SFI Electronics Technology Inc., Taoyuan City 333 (TW)
(72) Inventor: LIEN, Ching-Hohn, 333 Taoyuan City (TW); HSU, Hung-Tsung, 333 Taoyuan City (TW); HSU, Chih-Hsien, 333 Taoyuan City (TW); CHIU, Cheng-Hsien, 333 Taoyuan City (TW); HUANG, Hsing-Tsai, 333 Taoyuan City (TW)
(74) Representative: Zeitler Volpert Kandlbinder Patentanwälte Partnerschaft mbB

(57) **Abstract**

ESD suppressor and manufacturing method thereof. The ESD suppressor include at least two printed circuit boards, one insulating frame, two terminal electrodes and two or more interior electrodes. The insulating frame is positioned between the two printed circuit boards, so as to form a main structure with a cavity. For each printed circuit board, at least one interior electrode is positioned on the surface facing the cavity and separated from other interior electrode(s). Two terminal electrodes are positioned on two different surfaces of the main structure and electrically connected to different interior electrodes respectively. Optionally, the insulating frame is a hallowed out printed circuit board or a frame formed by printing insulating material. In the manufacturing method, the thickness of the insulating frame is adjusted to adjust the relative distance between different printed circuit boards, so as to further adjust the breakdown voltage of the ESD suppressor

## Description

### FIELD OF THE INVENTION

The present invention relates to an ESD suppressor and manufacturing method thereof, and more particularly to an ESD suppressor adjusts the breakdown voltage between different interior electrodes positioned on the opposite surfaces of two printed circuit boards by adjusting the thickness of an insulating frame positioned between the two printed circuit board and a manufacturing method thereof.

### BACKGROUND OF THE INVENTION

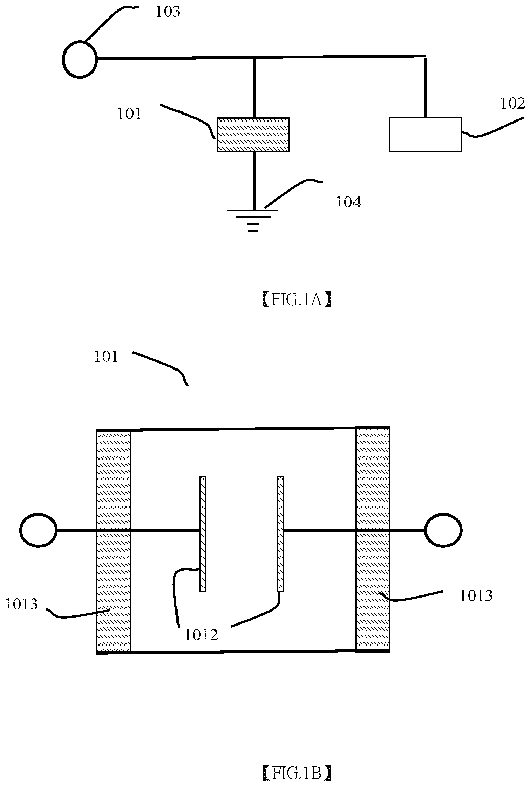

Electrostatic discharge suppressor (ESD suppressor) has been widely used to protect the integrated circuit from these damages caused by noises, surges and/or high voltage signals that are inevitable on the working environment. As shown in FIG. 1A, the ESD suppressor 101 is in parallel with the integrated circuit 102 to be protected and is in serial with the circuit 103, also the two terminals of the ESD suppressor 101 are electrically connected to the circuits 103 and the potential ground 104. As shown in FIG. 1B, the basic configuration of the ESD suppressor 101 has a main structure 1011, two interior electrodes 1012 and two terminal electrodes 1013. The two interior electrodes 1012 are separated from each other inside the main structure 1011, and the two terminal electrodes 1013 are positioned outside the two opposite ends of the main structure 1011. Different terminal electrodes 1013 are electrically connected to different interior electrodes 1012, also are separately connected to the circuit 103 and the potential ground 104. Apparently, the breakdown voltage between different internal electrodes 1012 determines the required voltage that an electrical signal reaching an interior electrode 1012 must have so as to reach another interior electrode 1012 and then build the electrical connection between two terminal electrodes 1013. Apparently, when the voltage of the signal from the circuit 103 does not exceed the breakdown voltage of the ESD suppressor 101, the capacitance inside the ESD suppressor 101 prevent the signal from passing through the ESD suppressor 101 and then the signal is delivered into the integrated circuit 102. In contrast, when the voltage of the signal from the circuit 103 does exceed the breakdown voltage of the ESD suppressor 101, the capacitance inside the ESD suppressor 101 can not prevent the signal from passing through the ESD suppressor 101 into the potential ground 103, and then the integrated circuit 102 is protected from the influence of the signal.

Various developments appeared in the recent years. For example, the working voltage of the integrated circuit is gradually decreased from 5 voltages in the early years to the 1 voltage. For example, a recent trend is to package the memory and the logic circuit together, so as to minimize the unavoidable supply noise, substrate noise and crosstalk on the working environment of the integrated circuit. For example, the static electric signal and noise are more and more serious for the increasingly popular wearable devices, mobile devices and touch panels, and then both the probability that the integrated circuit is damaged by the abnormal signal appeared on the circuits and the difficulty of layouting the integrated circuit with the peripheral circuit components (such as ESD suppressor and passive components) are irnegligibly increased. Therefore, the ESD suppressor with larger breakdown voltage, the ESD suppressor with faster response rate and /or the ESD suppressor occupying less circuit board area are becoming more and more valuable.

In summary, it is desired to develop new ESD suppressor and new manufacturing method, in order to meet the various requirements for ESD suppressor.

### SUMMARY OF THE INVENTION

The ESD suppressor proposed by the invention has the following basic configuration: Two printed circuit boards are positioned on the opposite sides of an insulating frame respectively, so as to form a main structure with a cavity inside. For each printed circuit board, one or more interior electrodes positioned on the surface facing another printed circuit board are exposed to the cavity, wherein different interior electrodes are separated away each other. Two terminal structures are positioned on the surface of the main structure and separated away each other, also different terminal structures are electrically connected different one or more interior electrodes. Moreover, two terminal electrodes are electrically connected to the circuit and the potential ground respectively.

Significantly, because the breakdown voltage between neighboring conductors are inversely proportional to the relative distances between neighboring conductors and also proportional to the total area of neighboring conductors, both the thickness of the insulating frame and the spatial configurations of these interior electrodes exposed to the cavity are the key factors to decide the breakdown voltage of the ESD suppressor proposed by this invention, also are the main variables to be adjusted according to the required breakdown voltage of the ESD suppressor.

The proposed invention only requires the insulating frame to meet two conditions and allows other portions of the insulating frame to be adjusted according to the actual needs. First condition, the insulating frame and two neighboring printed circuit board may together surround a cavity, such that the point discharge between different interior electrodes positioned on different printed circuit board may be happened when the voltage difference therebetween is large enough. Second condition, these interior electrodes are electrically insulated away the exterior of the ESD suppressor, no matter whether discharge is happened between different interior electrodes exposed to the cavity.

For example, the insulating frame may be a hallowed printed circuit board. Such design has the following advantages. First, both the process to hollow out printed circuit board and the process to place two printed circuit boards on opposite sides of the hollowed printed circuit board are simple. Second, the cost of the printed circuit board is not expensive. Especially, no high temperature process is required, and then the negative influence on the printed circuit board, the interior electrode and the terminal electrode may be reduced.

For example, the insulating frame may be a frame formed by using a printing process to treat the insulating material. Such design has the following advantages. First, how to print the insulating material to form a frame is a well-known technology. Second, are numerous commercial insulating materials may be chosen to be treated by the printing process. Especially, no high temperature process is required, at most about 100 degrees Celsius to 200 degrees Celsius is required, and then the negative influence on the printed circuit board, the interior electrode and the terminal electrode may be reduced. Besides, it is easy to adjust the thickness of the impression during the process of printing the insulating material. Hence, the thickness of the insulating material filled into the hole(s) of the impression may be further adjusted, and then the thickness of the insulating frame may be simply adjusted.

For example, in the one or more interior electrodes formed on the first surface and the second surface respectively, all of the area, the shape and the position of each interior electrode affect the breakdown voltage between these interior electrodes exposed to the cavity. Specially, along the direction vertical to the first surface or the second surface, the one or more interior electrodes on the first surface are usually at least partially overlapped with the one or more interior electrodes on the second surface. In this way, the capacitance value between the two printed circuit board is effectively increased, and then a larger breakdown voltage of the ESD suppressor is allowed.

Further, due to the main structure with cavity inside is formed by using two printed circuit board and an insulating frame, the negative influence induced by the parasitic capacitance may be effectively decreased by selecting the used printed circuit board. In this way, the breakdown voltage of the ESD suppressor is essentially decided by the breakdown voltage between the interior electrodes positioned on the opposite sides of the cavity. For example, the used printed circuit board may be the printed circuit board with low dielectric coefficient, such as the printed circuit board with dielectric coefficient not large than 6.0 may reduce the capacitance value to be lower than 0.2 pf during some tests, also such as the printed circuit board with dielectric coefficient not large than 4.4 may reduce the capacitance value to 0.05 pf during some tests. For example, when considering other requirements such as reducing parasitic capacitance and maintaining both the structural strength and electrical insulation of the printed circuit board, it is even possible to use the printed circuit board with dielectric coefficient between 1.5 and 3.5. In other words, the invention need not to limit the specific details of the printed circuit board. Owing to the basic structure of the printed circuit board is forming the metal circuit on the substrate, the substrate of each printed circuit board may be glass fiber board, bakelite board, plastic board or ceramic substrate. Even bakelite board, phenolic cotton paper, combination of epoxy resin and tissue paper, the combination of epoxy resin and glass cloth, the combination of polyester and matter glass, the combination of glass cloth and epoxy resin, the combination of tissue paper and flame-retardant epoxy resin, the combination of tissue paper and non-flame-retardant epoxy resin, Teflon, metal, Alumina, aluminum nitride, and silicon carbide may be used to as the substrate of each printed circuit board.

The ESD suppressor manufacturing method proposed by this invention has the following basic procedure. First of all, form one or more required interior electrodes on the first surface of the first printed circuit board and the second surface of the second printed circuit board respectively. Next, form an insulating frame of the first surface of the first printed circuit board, wherein at least one or more interior electrodes are not covered by the insulating frame. Finally, place the second printed circuit board on the insulating frame, wherein at least one or more interior electrodes are not covered by the insulating frame. Hence, the first printed circuit board, the insulating frame and the second printed circuit board together surround a cavity, also at least one interior electrode on the first surface and at least one interior electrode on the second surface are exposed to the cavity.

The proposed invention does not limit how the insulating frame is formed on the first surface of the first printed circuit board. For example, the central portion of a printed circuit board may be removed to form a frame-like structure, and then the frame-like structure may be placed on the first surface to form the required insulating frame. For example, a printed circuit board may be placed on the first surface, and then the central portion of the printed circuit board may be removed to form the required insulating fame. For example, the printing process may be used to treat the insulating material, so as to directly form an insulating frame on the first surface of the first printed circuit board. For example, initially, an impression (such as a steel mold) with one or more holes may be placed on the first surface so that the positions of all of the holes correspond to the positions where the insulating frame is planned to be formed on the first surface. Then, the slurry made of the insulating material is poured on the impression (such as the steel mold). After that, the slurry is pushed by the scraper so that all of holes are fully filled by the slurry, Finally, the impression (such as the steel mold) is removed and then required insulating frame made of the insulating material is formed.

Apparently, during the formation of one or more interior electrodes on the first surface and the second surface, the area, the shape and the position of each interior electrode may be adjusted as needed, so as to further adjust the breakdown voltage between all interior electrodes exposed to the cavity. Especially, by adjusting the overlapped area between one or more interior electrodes on the first surface and one or more interior electrodes on the second surface along the direction vertical to the first surface or to the second surface, the capacitance between two printed circuit board may be more effectively adjusted, so as to further effectively adjust the breakdown voltage of the ESD suppressor.

Apparently, during the formation of the insulating frame on one printed circuit board, the thickness of the insulating frame may be adjusted, so as to adjust the distance between two printed circuit board after another printed circuit board being placed on another side of the insulating frame. For example, depending on how the insulating frame is formed, how to adjust the thickness of the insulating frame may be achieved by using different printed circuit board with different thickness, may be achieved by adjusting the thickness of the used impression (such as the metal mold) with one or more holes, or even may be achieved by adjusting the pressure applied on the insulating frame and/or the period of applying pressure on the insulating frame during the step of placing two printed circuit boards on the opposite sides of the insulating frame respectively. Therefore, the thickness of the insulating frame may be adjusted according to the required breakdown voltage of the ESD suppressor, such that the breakdown voltage between the one or more interior electrodes on the first printed circuit board and the one or more interior electrodes on the second printed circuit board may be adjusted accordingly.

The invention does need not to limit the formation, the position and the shape of any interior electrode and any terminal electrode, any well-known or to be appeared technology may be used. The only limitation is that one or more interior electrodes are exposed to the cavity for both the first surface of the first printed circuit board and the second surface of the second printed circuit board. For example, both the first printed circuit board and the second printed circuit board may have one and only one interior electrode exposed to the cavity, such that an electrical signal from the external circuit may be conducted through one terminal electrode, one interior electrode on the first printed circuit board, the cavity, one interior electrode on the second printed circuit board and another terminal electrode in sequence into the potential ground when the voltage of the electrical signal is large enough to overcome the breakdown voltage between two printed circuit boards. For example, first printed circuit board may have only one interior electrode and second printed circuit board may have two interior electrodes exposed to the cavity, such that an electrical signal from the external circuit may be conducted through one terminal electrode, one interior electrode on the second printed circuit board, the cavity, one interior electrode on the first printed circuit board, the cavity, one interior electrode on the second interior electrode and another terminal electrode in sequence into the potential ground when the voltage of the electrical signal is large enough to overcome the breakdown voltage between two printed circuit boards. For example, both the first printed circuit board and the second printed circuit board may have at least two interior electrodes exposed to the cavity, such that an electrical signal from the external circuit may be conducted through one terminal electrode, different interior electrodes on different printed circuit boards on two sides of the cavity repeatedly, one interior electrode on the second printed circuit board, another terminal electrode in sequence into the potential ground when the voltage of the electrical signal is large enough to overcome the breakdown voltage between two printed circuit boards. For example, first printed circuit board may have two or more interior electrodes exposed to the cavity wherein different interior electrodes are electrically connected to different terminal electrode, such that one and only one cavity (or viewed as one or more main structure) may be used to treat different noises and different surges from different external circuits because different terminal electrodes may be electrically connected to different external circuits respectively.

### BRIEF DESCRIPTION OF THE DRAWINGS

Other advantages, objectives and features of the present invention will become apparent from the following description referring to the attached drawings.
FIG. 1A schematically illustrates the application of the ESD suppressor, and FIG. 1B schematically illustrates the basic configuration of the ESD suppressor.
FIG. 2A to FIG. 2D schematically illustrates the cross-section of some proposed ESD suppressors respectively.
FIG. 3 schematically presents some test results of the proposed ESD suppressor.
FIG. 4 is the flowchart of the proposed ESD suppressor manufacturing method.
FIG. 5 to FIG. 8 schematically illustrates some variations of the proposed ESD suppressors respectively.
FIG. 9 to FIG. 10 schematically illustrates some variation of the proposed ESD suppressors.

### DETAILED DESCRIPTION OF THE INVENTION

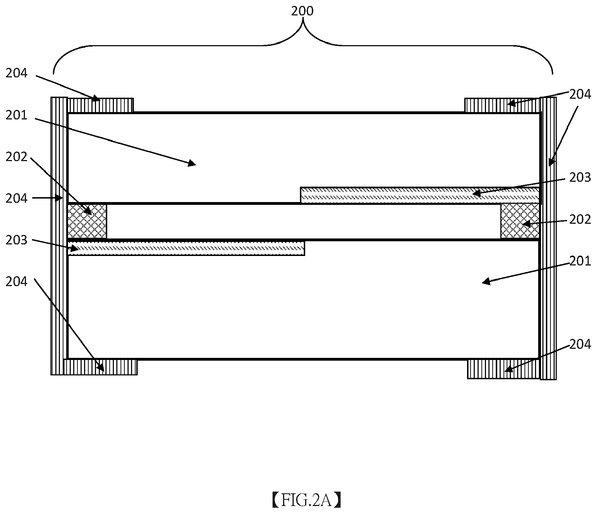

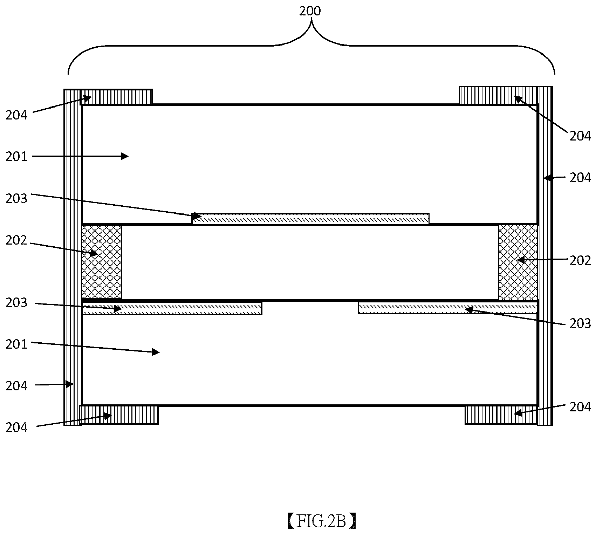

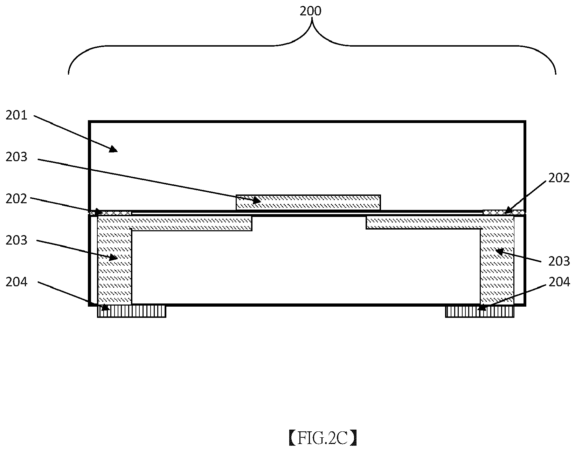

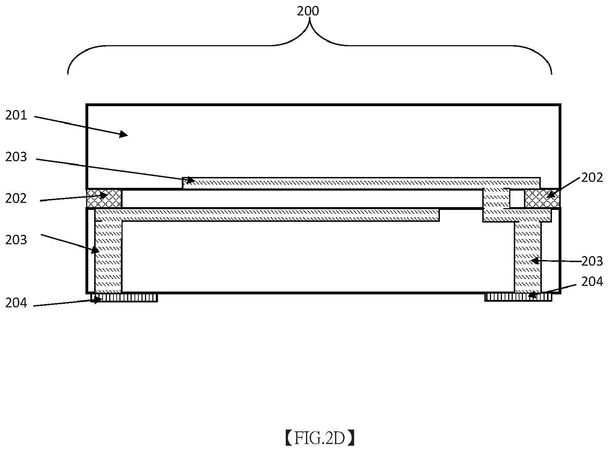

The invention proposes an ESD suppressor. As some embodiments shown in FIG. 2A to FIG. 2D, the ESD suppressor essentially includes two printed circuit boards 201, one insulating frame 202, some interior electrodes 203 and two terminal electrodes 204. Insulating frame 202 is a frame with the electrical insulation function, and two sides of the insulating frame 202 are connected to different printed circuit boards 201 respectively (or viewed as that the insulating frame 202 is sandwiched between the two printed circuit boards), such that a main structure with a cavity inside is formed by the three elements together. For each printed circuit board 201, one or more interior electrodes 203positioned on a surface facing the insulating frame 203 are exposed to the cavity. Two terminal electrodes 204 are positioned on the outer of two opposite sides of the main structure and are electrically connected to different interior electrodes 203 respectively.

The main features of the proposed ESD suppressor include the usage of the printed circuit boards, the usage of the insulating frame and the configuration of the interior electrodes. That is to say, in different embodiments, both the material and the function of each printed circuit board 201 are variable, the number of interior electrodes 203 positioned on any printed circuit board 201 and exposed to the cavity is variable, the shape and/or the area of any interior electrode 203 positioned on any printed circuit board 201 and exposed to the cavity is variable, and the overlapped ratio between different interior electrodes 203 positioned on different printed circuit board 201 along a direction vertical to any printed circuit board 201 is varied from zero to 100 %. Even both how different interior electrodes 203 are connected to the terminal electrode 204 and how different terminal electrodes are positioned on the outer of the main structure are variable. For example, two terminal electrodes 204 may be electrically connected different interior electrodes 203 positioned on the same printed circuit board 201, and also may be electrically connected to different interior electrodes 203 positioned on different printed circuit boards 201. For example, the opposite sides of the main structure may have an equal number of terminal electrodes 204, wherein one terminal electrode 204 positioned on one side is electrically connected to another terminal electrode 204 positioned on another side through at least two interior electrodes 203 inside the main structure, wherein different terminal electrodes 204 positioned on the two sides have a one-to-one correspondence with each other. For example, one interior electrode 203 may extend along the surface of one printed circuit board 201 where it is positioned to the edge of the printed circuit board 201, and then directly contacts with one terminal electrode 204 positioned on the side of the printed circuit board 201. For example, one interior electrode 203 may penetrate through the printed circuit board 201 where it is positioned, and then directly contacts with one terminal electrode 204 positioned on the bottom surface of the printed circuit board 201. Additionally, the material, the structure and the manufacturing method of both the interior electrodes 203 and the terminal electrodes 204 may be equal to both the interior electrode 203 and the terminal electrode 204 used by the conventional ESD suppressor. For example, for both the interior electrodes 203 and the terminal electrodes 204, the material may be copper, gold, silver or other metals. Here, FIG. 2A to FIG. 2D merely summarize the cross-sections of some possible variation.

For the proposed ESD suppressor 200, by properly choosing the material and the structure of each printed circuit board 201, the parasitic capacitance may be reduced, especially the capacitance vale between any printed circuit board 201 and one or more interior electrodes 203 positioned on the printed circuit board 201. Hence, the breakdown voltage of the ESD suppressor 200 may be almost only dependent on the breakdown voltage between different interior electrodes 203 positioned on two sides of the cavity respectively. Then, an ESD suppressor 201 with special breakdown voltage may be precisely provided by selecting an insulating frame with specific thickness and some interior electrodes 203 with specific shape and specific distribution.

For example, each the printed circuit boards 201 may be a printed circuit board with low dielectric coefficient, such as the printed circuit board with the dielectric coefficient not large than 6.0. According to some conducted tests, the usage of the printed circuit board with the dielectric coefficient not large than 6.0 may significantly reduce the parasitic capacitance between each printed circuit board 201 and one or more interior electrodes 203 positioned thereon. For example, to balance the requirement of reducing the parasitic capacitance and maintain both the structural strength and electrical insulation of the printed circuit boards 201, due to the material with very low or low dielectric coefficient may not satisfy all requirements of the printed circuit board 201, the printed circuit board with dielectric coefficient not large than 4.4 or even between 1.5 to 3.5 may be used, according to the evaluation of the commercial printed circuit board. Additionally, with the increasingly application of high-frequency signals, each printed circuit board may be a high-frequency printed circuit board 201. Further, the invention only requires that each printed circuit boards 201 has low dielectric coefficient, but the invention need not to limit other specific details of the two printed circuit boards 201, even need not to limit whether the two printed circuit board 201 have the same material, the same structure, the same size and/or the same shape. Because the main structure of the printed circuit board is forming the metal circuits on the substrate, the substrate of each printed circuit board 201 may be glass fiber board, bakelite, plastic board, or ceramic substrate, also may be any combination of these items. Even, the substrate of each printed circuit board 201 may be bakelite, phenolic tissue paper, the combination of epoxy resin and tissue, the combination of epoxy resin and glass cloth, the combination of polyester and matter glass, the combination of glass cloth and epoxy resin, the combination of tissue paper and flame-retardant epoxy resin, the combination of tissue paper and non-flame-retardant epoxy resin, Teflon, metal, Alumina, aluminum nitride, or silicon carbide, also may be any combination of these items.

For the proposed ESD suppressor 200, when an electrical signal appears on one terminal electrode 204 and then appears on one or more interior electrodes exposed to the cavity and electrically connected to the terminal electrode 204, any other interior electrode 203 may discharge with it is essentially the other one or more interior electrodes 203 positioned on another printed circuit board 201 and also exposed to the cavity. Therefore, to compare with some conventional ESD suppressors that different interior electrodes connected to different terminal electrodes are separated mutually and positioned on the same plane, the proposed ESD suppressor may let different interior electrodes 203 positioned on different printed circuit boards 201 are partially overlap with each other along a direction vertical to one of the printed circuit boards 201. Hence, the invention may adjust the breakdown voltage between different interior electrodes 203 positioned on opposite sides of the cavity by adjusting the position and/or the rear of each interior electrode 203, also may increase the breakdown voltage between different interior electrodes by increasing the overlapped area between the interior electrodes 203 positioned on the opposite sides of the cavity. In this way, the proposed ESD suppressor may achieve the higher breakdown voltage value and the breakdown voltage adjustment flexibility that these conventional ESD suppressor can mot achieve. Particularly, ESD suppressor 200 may let each of the two printed circuit board 201 has two interior electrodes 203 separated mutually and exposed to the cavity, such that any electrical signal appears on one terminal electrode 204 has to jump back and forth multiple times between two opposite sides of the cavity before it arriving another terminal electrode 204. In other words, the ESD suppressor 200 may let different interior electrode 203 be positioned at different positions of the two printed circuit board 201 and face each other, such that the electrical signal has to overcome several capacitances before it is conducted from one terminal electrode 204 to another terminal electrode 204. In this way, the available breakdown voltage value and breakdown voltage adjustment flexibility of the ESD suppressor 200 may be increased. Moreover, the ESD suppressor 200 may have at least three terminal electrodes 204, such that the ESD suppressor 200 may be electrically connected to some different external circuits (excluding the one or more terminal electrodes electrical connected to the potential grounds). In this way, the ESD suppressor 200 may be in parallel to some different integrated circuits and then provides protection to these different integrated circuits. Of course, the ESD suppressor 200 may have one or more separated mutually terminal electrodes 204 on the two opposite terminals and let both two printed circuit boards 201 and the insulating frame 202 together surrounds one or more cavities, such that the electrical signal from the external environment may be conducted through the same cavity (or viewed as through different interior electrodes 203 exposed to the same cavity) or through different cavities in sequence (or viewed as through different interior electrodes exposed to different cavities) during the period that the electrical signal is conducted between different interior electrodes 203. Also, the ESD suppressor 200 may have some number separated mutually terminal electrodes positioned on its two opposite terminals and let different terminal electrodes positioned on different terminal are corresponded one-to one, such that the ESD suppressor 200 may be flexibly electrically connected to different circuits and/or different potential ground, also may be divided into some ESD suppressors 200 with less terminal electrodes 204.

In some embodiments, the insulating frame 202 is a printed circuit board with a hollowed central portion. It may be a square frame or a rectangular frame formed by removing the central portions of a cuboid printed circuit board. In other words, by choosing the usage of different printed circuit board with different thickness, or even by thinning the printed circuit board during removing the central portions of the printed circuit board, the thickness of the insulating frame 202 may be adjusted so as to adjust the breakdown voltage of the ESD suppressor.

In some embodiments, the insulating frame 202 is a frame formed by using a printing process to treat the insulating material. For example, initially, an impression (such as a mold) is placed on a printed circuit board and the one or more hole of the impression is aligned to the positons of the cavity, and then the insulating frame 202 is acquired by removing the impression after the insulating material filled into the holes being solidified/hardened. In other words, by choosing the usage of different impressions with different thickness, by choosing the usage of different holes with different depths, or even by adjusting how the holes are filled by the insulating materials, the thickness of the insulating frame maybe adjusted so as to adjust the breakdown voltage of the ESD suppressor 200. In general, the insulating material may be phenolic resin, epoxy resin, silicone resin, polyurethane, polyurethane, polyethylene, polypropylene, acrylic resin, and polystyrene, also may be any combination of those items.

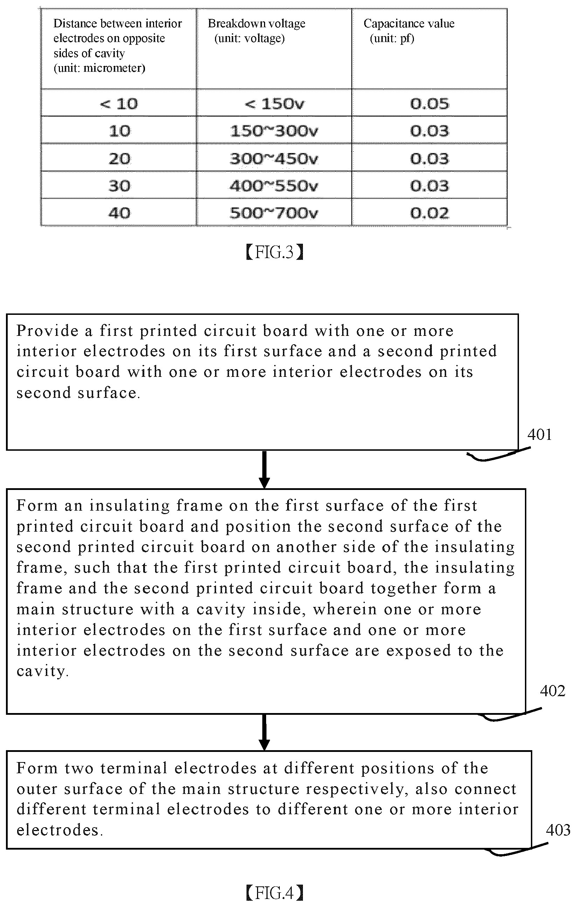

FIG. 3 briefly presents the test results of some embodiments. Among those embodiments, the thickness of each interior electrode 203 are fixed but the thickness of the insulating frame is adjusted respectively. The test results indicate that when the distance between interior electrodes 203 positioned on two sides of the cavity (or briefly viewed as the distance between two printed circuit boards) is gradually increased from 10 micrometers to 40 micrometers, the capacitance value between the two printed circuit boards is gradually decreased from 0.05 pf to about 0.02 pf and also the corresponding breakdown voltage is gradually increased from less than 105 voltage through 200 voltage to 700 voltage. Clearly, the test results indicate that both the capacitance value and the breakdown voltage of the ESD suppressor may be adjusted by adjusting the thickness of the insulating frame. In other words, the proposed ESD suppressor may adjust its structure details, such that how large signal the proposed ESD suppressor may block and how large signal the ESD suppressor may conduct to the potential ground may be simply adjusted without affecting the integrated circuits being in parallel to the proposed ESD suppressor.

The invention proposed a method of manufacturing ESD suppressor. As shown in the flowchart presented as FIG. 4, the manufacturing method includes the following basic steps. Initially, as shown in step 401, provide a first printed circuit board with one or more interior electrodes on its first surface and a second printed circuit board with one or more interior electrodes on its second surface. Next, as shown in step 402, form an insulating frame on the first surface of the first printed circuit board and position the second surface of the second printed circuit board on another side of the insulating frame, such that the first printed circuit board, the insulating frame and the second printed circuit board together form a main structure with a cavity inside, wherein one or more interior electrodes on the first surface and one or more interior electrodes on the second surface are exposed to the cavity. Finally, as shown in step 403, form two terminal electrodes at different positions of the outer surface of the main structure respectively, also connect different terminal electrodes to different one or more interior electrodes.

In some embodiments, the formation of the insulating frame in step 402 is achieved by removing the central portion of a printed circuit board. Here, the thickness of the insulating frame may be adjusted by adjusting the thickness of the hollowed printed circuit board, such as by using different printed circuit boards with different thickness, or even such as by removing a thin layer of the printed circuit board during the period of removing the central portion of the printed circuit board. In some other embodiments, the formation of the insulating frame in step 402 may be achieved by using the printing process to treat the insulating material to form a frame. Here, the thickness of the insulating frame maybe adjusted by adjusting the thickness of the insulating material filled into the holes of the impression used by the printing process. As usual, the insulating material may be phenolic resin, epoxy resin, silicone resin, polyurethane, polyurethane, polyethylene, polypropylene, acrylic resin, and polystyrene, also may be any combination of those items.

In some embodiments, the formation of the main structure by using the first printed circuit board, the second printed circuit board and the insulating frame together in step 401 may further adjusting the relative geometrical relation between these interior electrodes on the first surface and these interior electrodes on the second surface. For example, the position of at least one interior electrode may be adjusted, such that at least one interior electrode on the first surface is partially overlapped with at least one interior electrode on the second surface along a direction being vertical to the first surface and/or the second surface. By adjusting the overlapping ratio, the capacitance value in the cavity inside the main structure may be adjusted. For example, by adjusting the position of at least one interior electrode, it is possible that both the first surface and the second surface has one and only one interior electrode, and it is also possible that one surface has only one interior electrode and another surface has two separated mutually interior electrodes such that one interior electrode on one surface is positioned between the two separated mutually interior electrodes along a direction parallel to one surface.

The proposed ESD suppressor manufacturing method still may have other optional steps. For example, optionally, to use the high-frequency printed circuit board to be the first printed circuit board and/or the second printed circuit board. For example, optionally, to form a metal film on a surface of a printed circuit board facing another printed circuit board, such as a copper film, a gold film or a sliver film, and then optionally to transform the required circuits into the metal film before the un-desired portions of the metal film being removed and then one or more interior electrodes being formed on this surface.

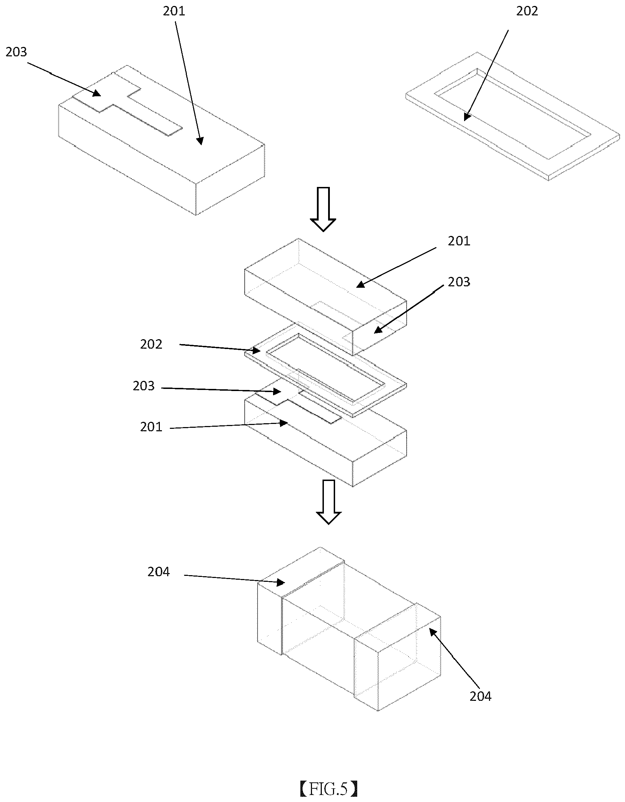

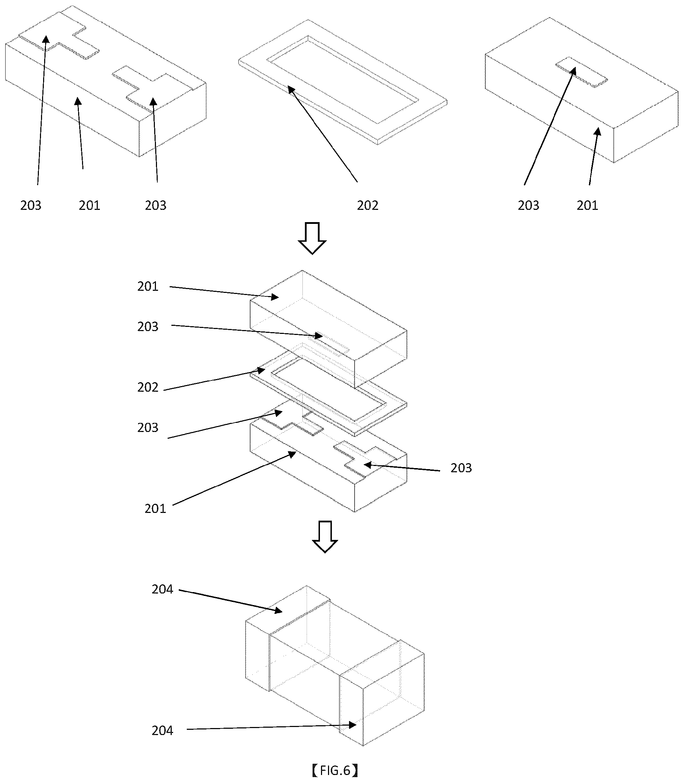

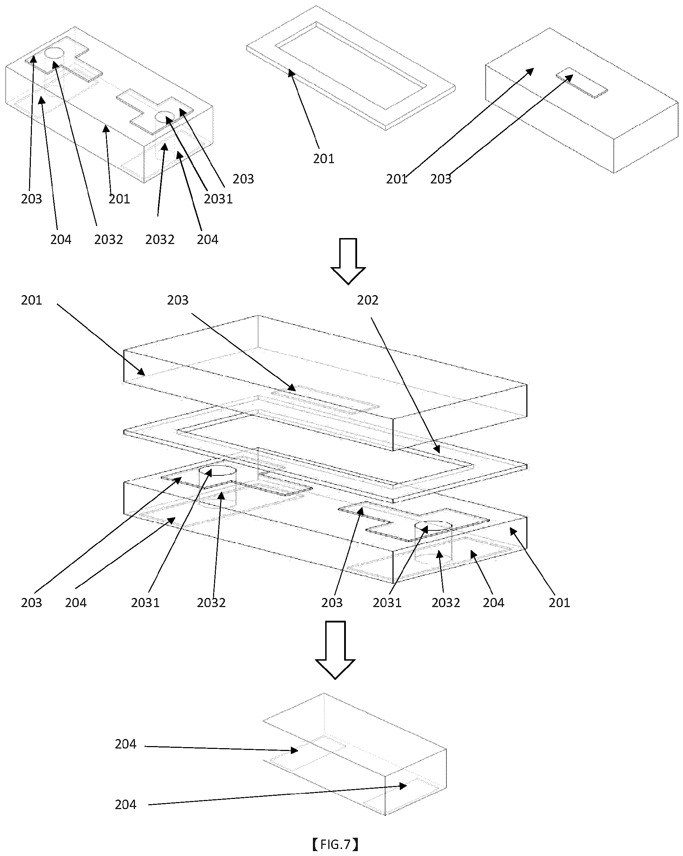

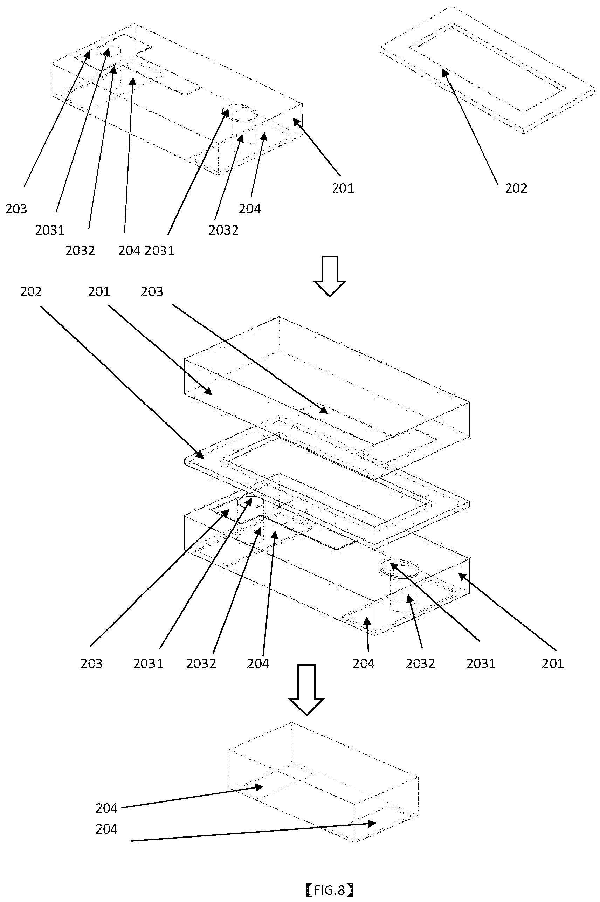

FIG. 5 to FIG. 8 briefly illustrated some examples of the proposed ESD suppressor and corresponding manufacturing method, which essentially are some application variations of these contents discussed previously. In FIG. 5, each printed circuit board 201 has one and only one interior electrode 203, and the two interior electrodes 203 is partially overlapped along a direction vertical to any printed circuit board when the two printed circuit boards 201 are positioned on the opposite sides of the insulating frame 202. Wherein, both interior electrodes 203 extends to the closed edge of corresponded printed circuit board 201, such that the terminal electrodes 204 may be the metal film positioned on the two terminals of the outer of the main structure formed by the two printed circuit boards 201 and the insulating frame 202. The main difference between FIG. 6 and FIG. 5 is FIG. 6 illustrating the situation that one printed circuit board 201 has two separated mutually interior electrodes 203 extending to the closed edges respectively and that another printed circuit 201 board has one and only one interior electrode 203 not extending to any edge of the printed circuit board 201. The main difference between FIG. 7 and FIG. 6 is FIG. 7 illustrating the situation that none of these interior electrodes 203 extending to any edge of the corresponded printed circuit board and that each of two interior electrodes 203 positioned on one printed circuit board 201 has one protrusion 2031. Here, both protrusions 2021 do not contact with the insulating frame 202 and may be connected to the two terminal electrodes 204 (not shown in FIG. 7) positioned on two terminals of the outer of the main structure through conductive structure (not shown in FIG. 7). The main difference between FIG. 8 and FIG. 5 is FIG. 5 illustrating the situation that each printed circuit board 201 has one and only one interior electrode 203. Here, for one of the two printed circuit boards 201, one terminal does not exist any protrusion 2031 capable of contacting with the insulating frame 202, also another terminal 201 has an interior electrode 203 not extending to any edge of this printed circuit board and exists the protrusion 2031 not contact with the insulating frame 202.

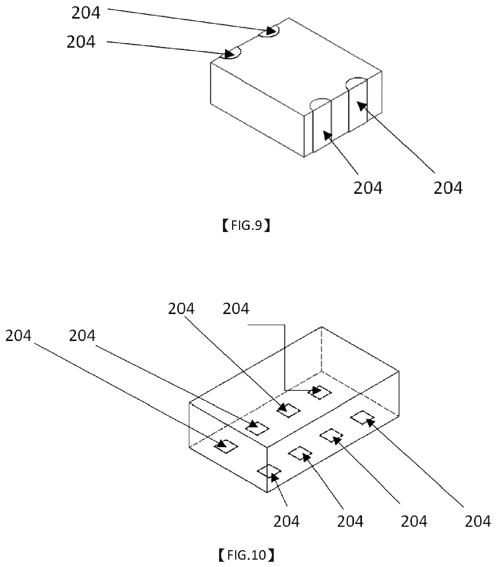

FIG. 9 to FIG. 10 briefly illustrates some examples of the proposed ESD suppressor and the proposed manufacturing method, which essentially are some application variations of these contents discussed previously. FIG. 9 illustrates the situation that each of the two opposite sides of the ESD suppressor has two separated mutually terminal electrodes 204. Any electrical signal appeared on one terminal electrode 204 on one side of the ESD suppressor may be conducted to two or more interior electrodes 203 (not shown in FIG. 9) positioned inside the ESD suppressor to another terminal electrode 204 positioned on another side of the ESD suppressor if the signal strength of the electrical signal is large enough. The main difference between FIG. 10 and Fig. 9 is both the positon and the number of these terminal electrodes 204. Here, these terminal electrodes 204 are not positioned on the opposite sides of the ESD suppressor but are positioned on two opposite sides of one surface of the ESD suppressor. Here, the number of these terminal electrodes 204 is increased to 8, and these terminal electrodes 204 are divided into two groups that each has four terminal electrodes 204. FIG. 9 and FIG. 10 are merely two examples of this invention, both are used to emphasize that this invention need not to limit to the number and the positions of these terminal electrodes 204. By adjusting the geometrical configuration of these terminal electrodes 204, how the ESD suppressor is connected to the external circuit(s) and the potential ground(s) are adjustable, how the interior of the ESD suppressor is configured to connect mutually these terminal electrodes 204 and these interior electrodes 203 is adjustable, even a large ESD suppressor may be simply divided into some small ESD suppressors.

While the invention has been described in terms of what is presently considered to be the most practical and preferred embodiments, it is to be understood that the invention needs not be limited to the disclosed embodiments. On the contrary, it is intended to cover various modifications and similar arrangements included within the spirit and scope of the appended claims which are to be accorded with the broadest interpretation so as to encompass all such modifications and similar structures.

## Claims

1. An ESD suppressor, comprising:
a first printed circuit board;
a second printed circuit board;
an insulating frame, positioned between first surface of the first printed circuit board and a second surface of the second printed circuit board so as to together form a main structure with a cavity inside;
two or more interior electrodes, positioned on the first printed circuit board and the second printed circuit board respectively, such that both the first surface and the second surface have one or more interior electrodes exposed to the cavity; and
two terminal electrodes, positioned at different portions of the outer surface of the main structure respectively, and electrically connected to different one or more interior electrodes respectively.

2. The ESD suppressor according to claim 1, further comprising at least one of the following:
the dielectric coefficient of the first printed circuit board is not large than 6.0;
the dielectric coefficient of the second printed circuit board is not large than 6.0;
the dielectric coefficient of the first printed circuit board is not large than 4.4;
the dielectric coefficient of the second printed circuit board is not large than 4.4;
the dielectric coefficient of the first printed circuit board is between 1.5 and 3.5; and
the dielectric coefficient of the second printed circuit board is between 1.5 and 3.5.

3. The ESD suppressor according to claim 1, further comprising at least one of the following:
the substrate of the first printed circuit board is chosen from the group consisting of the following: glass fiber board, bakelite, plastic board, ceramic substrate, and any combination thereof;
the substrate of the second printed circuit board is chosen from the group consisting of the following: glass fiber board, bakelite, plastic board, ceramic substrate, and any combination thereof;
the substrate of the first printed circuit board is chosen from the group consisting of the following: bakelite, phenolic tissue paper, the combination of epoxy resin and tissue, the combination of epoxy resin and glass cloth, the combination of polyester and matter glass, the combination of glass cloth and epoxy resin, the combination of tissue paper and flame-retardant epoxy resin, the combination of tissue paper and non-flame-retardant epoxy resin, Teflon, metal, Alumina, aluminum nitride, silicon carbide, and any combination thereof; and
the substrate of the second printed circuit board is chosen from the group consisting of the following: bakelite, phenolic tissue paper, the combination of epoxy resin and tissue, the combination of epoxy resin and glass cloth, the combination of polyester and matter glass, the combination of glass cloth and epoxy resin, the combination of tissue paper and flame-retardant epoxy resin, the combination of tissue paper and non-flame-retardant epoxy resin, Teflon, metal, Alumina, aluminum nitride, silicon carbide, and any combination thereof

4. The ESD suppressor according to claim 1, further comprising at least one of the following:
the one or more interior electrodes positioned on the first surface are at least partially overlapped with the one or more interior electrodes positioned on the second surface along a direction vertical to the first surface;
the one or more interior electrodes positioned on the first surface are at least partially overlapped with the one or more interior electrodes positioned on the second surface along a direction vertical to the second surface;
one and only one interior electrode is positioned on the first surface and one and only one interior electrode is positioned on the second surface;
one and only one interior electrode is positioned on the first surface and two separated interior electrodes are positioned on the second surface, wherein the interior electrode on the first surface is positioned between the two separated interior electrodes on the second surface along a direction vertical to the first surface; and
one and only one interior electrode is positioned on the first surface and two separated interior electrodes are positioned on the second surface, wherein the interior electrode on the first surface is positioned between the two separated interior electrodes on the second surface along a direction vertical to the second surface.

5. The ESD suppressor according to claim 1, wherein the insulating frame is a printed circuit board with a hollowed central portion.

6. The ESD suppressor according to claim 1, wherein the insulating frame is a frame formed by using a printing process to treat the insulating material.

7. The ESD suppressor according to claim 6, wherein the insulating material is chosen from the group consisting of the following: phenolic resin, epoxy resin, silicone resin, polyurethane, polyurethane, polyethylene, polypropylene, acrylic resin, polystyrene, and any combination thereof.

8. A method of manufacturing the ESD suppressor, comprising:
providing a first printed circuit board, wherein one or more interior electrodes are positioned on its first surface;
providing a second printed circuit board, wherein one or more interior electrodes are positioned on its second surface;
forming an insulating frame on the first surface of the first printed circuit board and placing the second surface of the second printed circuit board on the opposite side of the insulating frame, such that the first printed circuit board, the insulating frame and the second printed circuit board together form a main structure with a cavity inside, wherein one or more interior electrodes on the first surface and one or more interior electrodes on the second surface are exposed to the cavity; and
forming two terminal electrodes at different positions of the outer surface of the main structure, wherein different interior electrodes are connected to different one or more interior electrodes respectively.

9. The method according to claim 8, further comprising at least one of the following:
using the first printed circuit board with the dielectric coefficient not large than 6.0;
using the second printed circuit board with the dielectric coefficient not large than 6.0;
using the first printed circuit board with the dielectric coefficient not large than 4.4;
using the second printed circuit board with the dielectric coefficient not large than 4.4;
using the first printed circuit board with the dielectric coefficient between 1.5 and 3.5; and
using the second printed circuit board with the dielectric coefficient between 1.5 and 3.5.

10. The method according to claim 8, further comprising at least one of the following:
using the first printed circuit board whose substrate is chosen from the group consisting of the following: glass fiber board, bakelite, plastic board, ceramic substrate, and any combination thereof;
using the second printed circuit board whose substrate is chosen from the group consisting of the following: glass fiber board, bakelite, plastic board, ceramic substrate, and any combination thereof;
using the first printed circuit board whose substrate is chosen from the group consisting of the following: bakelite, phenolic tissue paper, the combination of epoxy resin and tissue, the combination of epoxy resin and glass cloth, the combination of polyester and matter glass, the combination of glass cloth and epoxy resin, the combination of tissue paper and flame-retardant epoxy resin, the combination of tissue paper and non-flame-retardant epoxy resin, Teflon, metal, Alumina, aluminum nitride, silicon carbide, and any combination thereof; and
using the second printed circuit board whose substrate is chosen from the group consisting of the following: bakelite, phenolic tissue paper, the combination of epoxy resin and tissue, the combination of epoxy resin and glass cloth, the combination of polyester and matter glass, the combination of glass cloth and epoxy resin, the combination of tissue paper and flame-retardant epoxy resin, the combination of tissue paper and non-flame-retardant epoxy resin, Teflon, metal, Alumina, aluminum nitride, silicon carbide, and any combination thereof

11. The method according to claim 8, further comprising at least one of the following:
positioning one or more interior electrodes such that the one or more interior electrodes positioned on the first surface are at least partially overlapped with the one or more interior electrodes along a direction vertical to the first surface;
positioning one or more interior electrodes such that the one or more interior electrodes positioned on the first surface are at least partially overlapped with the one or more interior electrodes along a direction vertical to the second surface;
positioning one and only one interior electrode on the first surface and positioning one and only one interior electrode on the second surface;
positioning one and only one interior electrode on the first surface and positioning two separated interior electrodes on the second surface, such that the interior electrode on the first surface is positioned between the two separated interior electrodes on the second surface along a direction vertical to the first surface; and
positioning one and only one interior electrode on the first surface and positioning two separated interior electrodes on the second surface, such that the interior electrode on the first surface is positioned between the two separated interior electrodes on the second surface along a direction vertical to the second surface.

12. The method according to claim 8, further comprising hollowing the central portion of a printed circuit board to form the insulating frame.

13. The method according to claim 8, further comprising using a printing process to treat the insulating material for forming the insulating frame.

14. The method according to claim 13, further comprising using the insulating material chosen from the group consisting of the following: phenolic resin, epoxy resin, silicone resin, polyurethane, polyurethane, polyethylene, polypropylene, acrylic resin, polystyrene, and any combination thereof.

15. The method according to claim 8, further comprising one of the following:
transforming the required circuit into a metal film formed on the first surface of the first printed circuit board, and then removing the un-desired portions of the metal film so as to form one or more interior electrodes on the first surface; and
transforming the required circuit into a metal film formed on the second surface of the second printed circuit board, and then removing the un-desired portions of the metal film so as to form one or more interior
electrodes on the second surface.
